# EUROPEAN PATENT APPLICATION

(11) **EP 0 855 720 A2**
(43) Date of publication of application: **29.07.1998**
(21) Application number: 98101003.6
(22) Date of filing: 21.01.1998
(51) Int. Cl.: H01B 1/22

(54) **Electroconductive copper paste composition**

(30) Priority: 28.01.1997 JP 14164/97; 10.06.1997 JP 152062/97; 10.06.1997 JP 152063/97
(71) Applicant: SUMITOMO BAKELITE COMPANY LIMITED, Tokyo 140 (JP)
(72) Inventor: Komiyatani, Toshio, Fujieda-shi (JP); Takahashi, Yoshiyuki, Fujieda-shi (JP)
(74) Representative: Vossius, Volker, Dr.

(57) **Abstract**

An electroconductive copper paste composition comprising a copper powder, a thermosetting resin and a solvent as essential components, characterized in that the copper powder has a dendrite shape having an average particle diameter of 1 to 25 µm and a BET specific surface area of 2,000 to 6,300 cm²/g, which composition imparts a high reliability and a high electroconductivity to the through hole portion or the like of a printed circuit substrate.

## Description

This invention relates to an electroconductive copper paste composition, and particularly to an electroconductive copper paste composition excellent in reliability of the through hole portion in a printed circuit substrate. More particularly, it relates to such an electroconductive copper paste composition that when the electroconductive copper paste composition is embedded by screen printing in the through hole portion provided in a printed circuit substrate obtained by processing a paper-based phenol resin copper-clad laminate, a glass cloth-based epoxy resin copper-clad laminate or the like and then heated and cured, a good electroconductivity is imparted to the through hole portion and even after moisture absorption, no electroconductivity failure is caused by thermal shock in the through hole portion.

As a matter of course, the electroconductive copper paste composition can be used as a conductor for not only through hole but also BVH (Buried Via Hole) and also as a conductor for a circuit such as a jumper circuit or the like.

Recently, there has become popular a process for producing a printed circuit board which comprises providing a through hole in the land portion of a circuit in a printed circuit substrate obtained by processing a paper-based phenol resin copper-clad laminate, a glass cloth-based epoxy resin copper-clad laminate or the like, embedding an electroconductive silver paste in the through hole by screen printing and then heating and curing the paste. However, when a silver paste is used, since, particularly recently, the circuit pattern has been made finer, there is such a problem that migration of silver is often caused. Moreover, silver is excellent in electroconductivity but is an expensive metal.

On the other hand, as a connection method for through hole, a connection-by-copper-plating method is also broadly known. However, this method has a problem of control of plating solution, an environmental problem of its waste liquid or the like. Therefore, a connection method comprising embedding an electroconductive copper paste attracts attention because the electroconductive copper paste is low in total cost and can be used in only the necessary places, and the use of the above connection method is increasing.

The electroconductive copper paste is usually composed of a copper powder, a thermosetting resin which is a binder, a solvent and the like.

However, copper is easily oxidized and the resulting oxide is an insulator, so that a substance having an action of reducing the oxidized copper is usually compounded with the copper paste in order to effectively inhibit the oxidation of copper. As a measure for preventing such an oxidation, there are known those described in, for example, JP-A-61-3,154, JP-A-63-286,477 and the like. However, in the case of the copper paste, ohmic contact is not obtained unless the copper powder particles are sufficiently contacted with one another, and the copper paste has not yet been used as a substitute for the silver paste.

As a copper paste for through hole, copper pastes which impart a good electroconductivity to the through hole portion and do not cause electroconductivity failure of the through hole portion by a thermal shock such as cooling-heating cycle, solder dip or the like, have heretofore been provided by embedding the copper paste in the through hole portion by screen printing and thereafter heating and curing the copper paste as stated in JP-A-8-73,780; JP-A-8-153,942; JP-A-9-12,937; JP-A-9-69,314; and the like.

In order to develop this electroconductivity, it is necessary to press copper powder particles to one another in the paste by means of the shrinking force of a binder (thermosetting resin) present around the particles to sufficiently contact them. For this purpose, it becomes necessary to optimize the amounts of the copper powder and binder compounded depending on the degree of shrinkage of the binder. Moreover, in order to increase the above electroconductivity, that is, to lower the electroconductive resistance, the shape of copper powder becomes an important element.

The present inventors have noticed that when the copper powder particles are pressed to one another, it is necessary to increase the contact area between the particles in order to lower the electroconductive resistance, and have consequently obtained a copper paste excellent in electroconductivity and reliability by allowing the copper powder particles to have a specific shape.

This invention relates to an electroconductive copper paste composition comprising a copper powder, a thermosetting resin and a solvent as essential components, characterized by using a dendrite copper powder having an average particle diameter of 1 to 25 µm and a BET specific surface area of 2,000 to 6,300 cm²/g. Preferably, the copper powder is further characterized by having an apparent density of 1.0 to 4.0 g/cm³ and a tap density of 3.0 to 4.0 g/cm³. By using a copper powder having such a specific shape, the contact of copper powder particles with one another becomes good and the conduction resistance value becomes small. In addition, the screen printing can be well conducted.

When the average particle diameter is less than 1 µm, the number of contact points between the copper powder particles is increased, but the contact area is simultaneously decreased. As a result, the electroconductive resistance becomes high. Moreover, their surfaces are easily oxidized and their handling becomes difficult. When the average particle diameter exceeds 25 µm, the particles cannot pass through the screen in the screen printing and tend to cause clogging.

When the BET specific surface area of the dendrite copper powder exceeds 6,300 cm²/g, the ramified portion of the dendrite is too large and it follows that the volume of spaces present per one particle is increased. Therefore, when the copper powder particles are pressed to one another, the contact area becomes small, so that the electroconductive resistance becomes high. When the BET specific surface area is less than 2,000 cm²/g, the volume of spaces becomes small, but the ramified portion of the dendrite becomes small (namely, close to sphere), and hence, the contact area becomes similarly small and the electroconductive resistance becomes high.

Moreover, the apparent density of the dendrite copper powder is preferably 1.0 to 4.0 g/cm³ and the tap density thereof is preferably 3.0 to 4.0 g/cm³. The apparent density is measured according to the method defined in JIS Z 2504. The tap density is measured according to the method defined in ISO 3953. When the apparent density is less than 1.0 g/cm³ or the tap density is less than 3.0 g/cm³, the ramified portion of the dendrite is too large, the volume of spaces present per one copper powder particle becomes large, and the contact area when the copper powder particles are pressed to one another becomes small, so that the conduction resistance value becomes high. Contrarily, when the apparent density exceeds 4.0 g/cm³ or the tap density exceeds 4.0 g/cm³, the volume of spaces per one copper particle becomes small but the ramified portion of the dendrite becomes small (namely close to sphere), the contact area becomes similarly small and the conduction resistance value becomes high.

The thermosetting resin used as a binder in this invention is preferably the so-called resole type phenol resin which is a methylolation or dimethylene etherification product obtained by reacting phenol with formaldehyde in the presence of an alkali catalyst in order to press copper powder particles to one another to give good electroconductivity.

Furthermore, particularly, in the case of being embedded in the through hole or BVH by the screen printing, preferred is a resole type phenol resin having a weight average molecular weight of not less than 1,000 but not more than 5,000 for increasing the flowability. When the weight average molecular weight exceeds 5,000, the gas generated from particularly a paper-based phenol resin copper-clad laminate when the through hole in the substrate is filled with the electroconductive copper paste composition and this composition is cured, is not completely removed, whereby molding failure such as void, blister or the like tends to be caused. When the weight average molecular weight is less than 1,000, the binding force becomes weak and the cured product becomes inferior in electroconductivity and simultaneously becomes brittle, and hence, when the substrates are put one on another, they are broken and chipped in some cases.

Furthermore, if necessary, an adhesion-imparting agent such as liquid rubber, polyvinyl butyral, polysiloxane or the like and a flexible resin may be blended.

The amount of the resole type phenol resin blended is preferably 10 to 40 parts by weight, more preferably 20 to 30 parts by weight, per 100 parts by weight of the copper powder in order to develop a great binding force and a good electroconductivity. When the above amount is less than 10 parts by weight per 100 parts by weight of the copper powder, the binding force becomes insufficient. Therefore, the copper powder particles are not sufficiently pressed to one another, and no good electroconductivity is developed, which results in a reduction of reliability. When the amount of the resole type phenol resin blended exceeds 40 parts by weight per 100 parts by weight of the copper powder, the part of insulating material becomes excessive and the contact between copper powder particles becomes insufficient, so that the initial electroconductive resistance becomes high and the electroconductive copper paste composition becomes unusable in practice.

In this invention, it is preferable to use ultrafine particles of silica. The silica has preferably a primary particle diameter of 0.005 to 0.05 µm. The purpose of compounding the silica is the control of flowability, and when the primary particle diameter is less than 0.005 µm, a thixotropic effect is obtained but such particles are not commercially available. When the primary particle diameter exceeds 0.05 µm, the thixotropic effect is lowered and simultaneously the particles of the silica get jammed in between the copper powder particles to remarkably lower the electroconductivity. The amount of the ultrafine particles of silica compounded is preferably 1 to 5 parts by weight per 100 parts by weight of the copper powder. When the amount is less than 1 part by weight, the flowability control effect is small, and bleeding is caused in some cases during printing. When the amount exceeds 5 parts by weight, the electroconductivity is remarkably lowered. Moreover, in order to make the dispersibility good, ultrafine particles of silica which have been made hydrophobic are more preferably used.

In this invention, it is preferable to use a titanate coupling agent. This is a titanate compound having a hydrophilic group and a hydrophobic group and in this invention, it imparts thermal shock resistance based on the dispersibility of the copper powder and the effect of coupling with the resin. For example, Plenact which is put on the market from Ajinomoto Co., Inc. or the like can be used.

By compounding a titanate coupling agent, the initial electroconductivity can be prevented from being deteriorated, and thermal shock resistance, heat resistance and the like can be imparted. The effect thereof appears when the amount of the coupling agent is 0.1 part by weight per 100 parts by weight of the copper powder and does not substantially change even when the amount exceeds 1 part by weight per 100 parts by weight of the copper powder.

As the solvent used in this invention, it is preferable to select solvents which satisfy both that the drying of the screen printing plate is inhibited and that the ink (paste composition) after the printing is easy to dry. For this purpose, the following glycol ethers are preferable, and an appropriate one is selected from them depending on the equipment ability and the use conditions. There are used, for example, ethylene glycol monomethyl ether, ethylene glycol monoethyl ether, diethylene glycol monomethyl ether, triethylene glycol monomethyl ether, propylene glycol monomethyl ether, dipropylene glycol monomethyl ether, propylene glycol monopropyl ether, dipropylene glycol monopropyl ether, ethylene glycol monoisopropyl ether, diethylene glycol monoisopropyl ether, ethylene glycol monobutyl ether, diethylene glycol monobutyl ether, triethylene glycol monobutyl ether, propylene glycol monobutyl ether, dipropylene glycol monobutyl ether, ethylene glycol monoisobutyl ether, diethylene glycol monoisobutyl ether, ethylene glycol monohexyl ether, diethylene glycol monohexyl ether, ethylene glycol mono-2-ethylhexyl ether, ethylene glycol monoallyl ether, ethylene glycol monophenyl ether, ethylene glycol dimethyl ether, diethylene glycol dimethyl ether, diethylene glycol diethyl ether, diethylene glycol dibutyl ether, triethylene glycol dimethyl ether and the like, and their esterified products. However, it is necessary to select those having an appropriate boiling point and vapor pressure depending upon the solubility of the thermosetting resin used, the drying conditions after the printing on the circuit substrate, and the like, and a mixed system of at least two of the above solvents can also be used.

As a process for producing an electroconductive copper paste composition, various processes can be applied; however, it is general to mix the constituents, then knead the resulting mixture on a triple roll mill, a planetary mixer or the like to obtain the composition. Moreover, it is also possible to add, if necessary, an antioxidant, a dispersing agent, a defoaming agent, a leveling agent or the like to the composition.

The electroconductive copper paste composition of this invention is an electroconductive copper paste composition which is excellent particularly in the reliability of the through hole portion in a printed circuit substrate. More particularly, when the electroconductive copper paste composition is embedded by screen printing in the through hole portion provided in a printed circuit substrate obtained by processing a paper-based phenol resin copper-clad laminate, a glass cloth-based epoxy resin copper-clad laminate or the like and thereafter heated and cured, a good electroconductivity is imparted to the through hole portion, the soldering heat resistance after moisture absorption is not deteriorated, and electroconductivity failure is not caused by thermal shock in the through hole portion, so that electric connection with a high reliability becomes possible.

Examples and Comparative Examples are shown below to explain this invention in more detail.

### Example 1

A dendrite electrolytic copper powder (Copper Powder A) having an average particle diameter of 5 µm, an apparent density of 2.0 g/cm³, a tap density of 3.0 g/cm³ and a BET specific surface area of 5,200 cm²/g as a copper powder, a liquid resole type phenol resin having a weight average molecular weight of 1,200 as a binder resin, and a mixed solvent of ethylene glycol monobutyl ether, propylene glycol monobutyl ether and propylene glycol monopropyl ether as a solvent were kneaded together with the coupling agent and additive shown in Table 1 in the proportions shown in the Table 1 on a triple roll mill to obtain an electroconductive copper paste composition.

The 0.5-mm⌀ through hole provided in a paper-based phenol resin substrate PLC-2147RH (plate thickness: 1.6 mm) manufactured by Sumitomo Bakelite Co., Ltd. was filled with the electroconductive copper paste composition thus obtained by a screen printing method, and the electroconductive copper paste composition was cured at 150°C for 30 minutes in a box-shaped hot air drying machine.

The electroconductivity of the resulting test piece per one through hole was confirmed by measuring its resistance value. Thereafter, the test piece was subjected to a soldering heat resistance test after moisture absorption and a cooling-heating cycle test to determine the respective resistance values in the same manner as above. Thereafter, the cross section of the through hole was observed to confirm whether or not crack or peel was caused in the cured copper paste. The results obtained are shown in Table 1.

### Example 2

The same procedure as in Example 1 was repeated, except that a dendrite electrolytic copper powder (Copper Powder B) having an average particle diameter of 10 µm, an apparent density of 2.8 g/cm³, a tap density of 4.0 g/cm³ and a BET specific surface area of 2,500 cm²/g was substituted for the Copper Powder A, to obtain an electroconductive copper paste composition, and the same evaluation as in Example 1 was conducted. The results obtained are shown in Table 1.

### Example 3

The same procedure as in Example 1 was repeated, except that a dendrite electrolytic copper powder (Copper Powder C) having an average particle diameter of 15 µm, an apparent density of 4.0 g/cm³, a tap density of 4.8 g/cm³ and a BET specific surface area of 2,000 cm²/g was substituted for the Copper Powder A, to obtain an electroconductive copper paste composition, and the same evaluation as in Example 1 was conducted. The results obtained are shown in Table 1.

### Example 4

The same procedure as in Example 1 was repeated, except that a dendrite electrolytic copper powder (Copper Powder D) having an average particle diameter of 5 µm, an apparent density of 2.6 g/cm³, a tap density of 4.3 g/cm³ and a BET specific surface area of 3,800 cm²/g was substituted for the Copper Powder A, to obtain an electroconductive copper paste composition, and the same evaluation as in Example 1 was conducted. The results obtained are shown in Table 1.

### Comparative Example 1

The same procedure as in Example 1 was repeated, except that a dendrite electrolytic copper powder (Copper Powder E) having an average particle diameter of 30 µm, an apparent density of 0.8 g/cm³, a tap density of 1.4 g/cm³ and a BET specific surface area of 4,600 cm²/g was substituted for the Copper Powder A, to obtain an electroconductive copper paste composition, and the same evaluation as in Example 1 was conducted. The results obtained are shown in Table 1.

### Comparative Example 2

The same procedure as in Example 1 was repeated, except that a spherical copper powder (Copper Powder F) having an average particle diameter of 5 µm, an apparent density of 2.0 g/cm³, a tap density of 3.5 g/cm³ and a BET specific surface area of 8,700 cm²/g was substituted for the Copper Powder A, to obtain an electroconductive copper paste composition, and the same evaluation as in Example 1 was conducted. The results obtained are shown in Table 1.

### Measurement methods

1. Soldering heat resistance test after moisture absorption: The test piece was subjected to moisture absorption treatment at a temperature of 40°C at a relative humidity of 95% for 96 hours, and then dipped in a solder bath at 260°C for 5 seconds. This procedure was conducted twice.
2. Cooling-heating cycle test: A -65°C, 30 min. ← → 125°C, 30 min. thermal cycle test was repeated by 1,000 cycles.

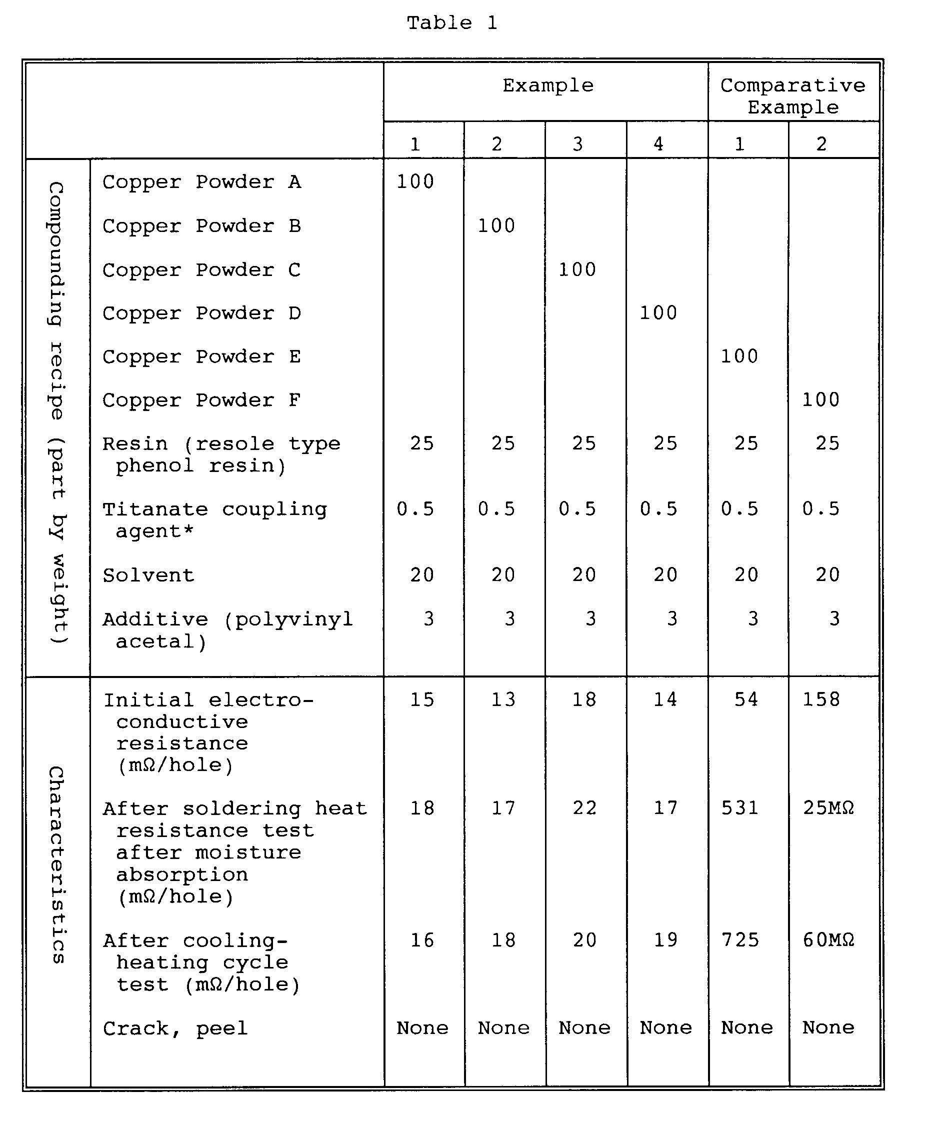

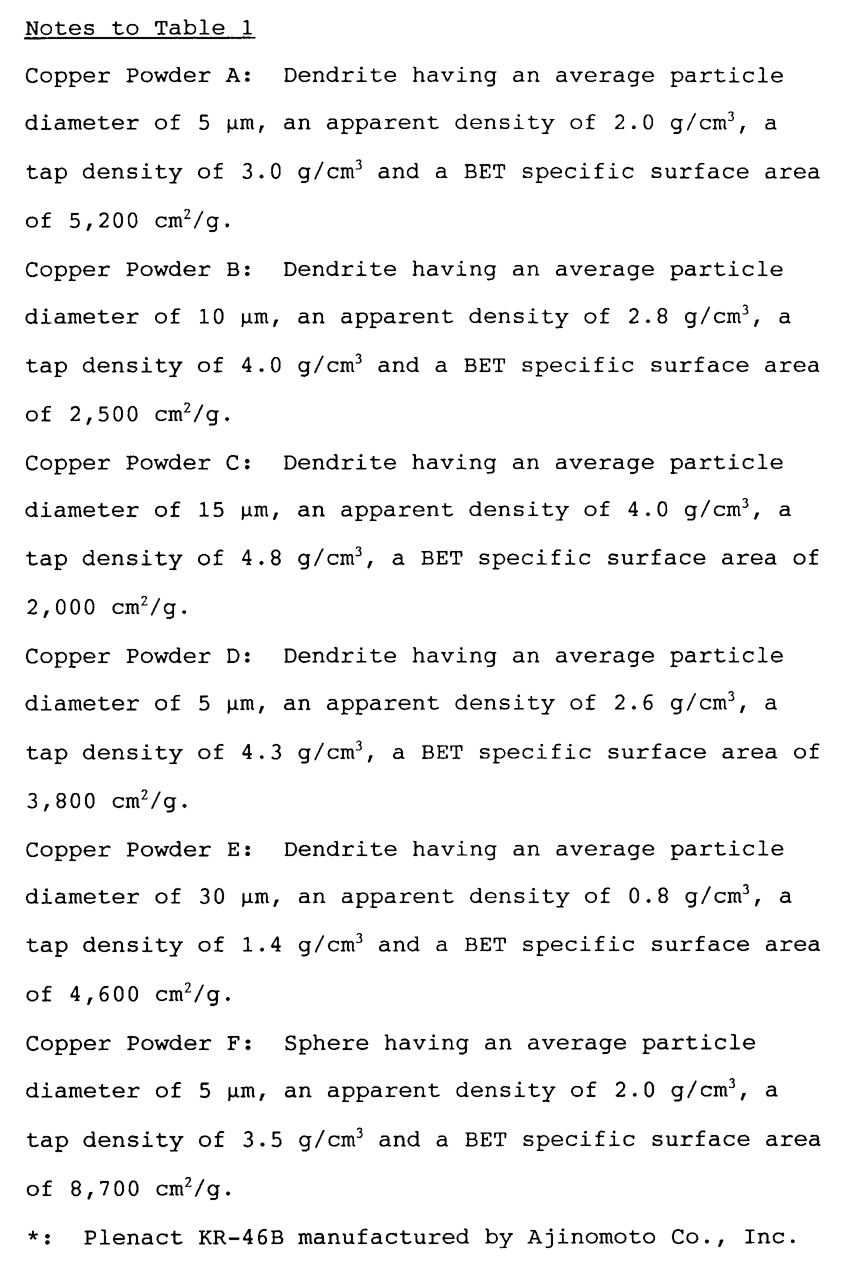

## Claims

1. An electroconductive copper paste composition comprising a copper powder, a thermosetting resin and a solvent as essential components, characterized in that the copper powder has a dendrite shape having an average particle diameter of 1 to 25 µm and a BET specific surface area of 2,000 to 6,300 cm²/g.

2. The electroconductive copper paste composition according to Claim 1, wherein the thermosetting resin is a resole type phenol resin, which is contained in a proportion of 10 to 40 parts by weight per 100 parts by weight of the copper powder.

3. The electroconductive copper paste composition according to Claim 2, wherein the resole type phenol resin has a weight average molecular weight of not less than 1,000 but not more than 5,000.

4. The electroconductive copper paste composition according to Claim 1, which further contains ultrafine particles of silica having a primary particle diameter of 0.005 to 0.05 µm in a proportion of 1 to 5 parts by weight per 100 parts by weight of the copper powder.

5. The electroconductive copper paste composition according to Claim 1, which further contains a titanate coupling agent in a proportion of 0.1 to 1.0 part by weight per 100 parts by weight of the copper powder.

6. The electroconductive copper paste composition according to Claim 1, wherein the copper powder has an apparent density of 1.0 to 4.0 g/cm³ and a tap density of 3.0 to 4.0 g/cm³.

7. The electroconductive copper paste composition according to Claim 6, wherein the thermosetting resin is a resole type phenol resin and is contained in a proportion of 10 to 40 parts by weight per 100 parts by weight of the copper powder.

8. The electroconductive copper paste composition according to Claim 7, wherein the resole type phenol resin has a weight average molecular weight of not less than 1,000 but not more than 5,000.

9. The electroconductive copper paste composition according to Claim 6, which further contains ultrafine particles of silica having a primary particle diameter of 0.005 to 0.05 µm in a proportion of 1 to 5 parts by weight per 100 parts by weight of the copper powder.

10. The electroconductive copper paste composition according to Claim 6, which further contains a titanate coupling agent in a proportion of 0.1 to 1.0 part by weight per 100 parts by weight of the copper powder.
